# EUROPEAN PATENT APPLICATION

(11) **EP 0 535 568 A1**
(43) Date of publication of application: **07.04.1993**
(21) Application number: 92116545.2
(22) Date of filing: 28.09.1992
(51) Int. Cl.: C23G 5/00, C23C 2/02, H01J 37/34

(54) **Metal strip surface cleaning apparatus**

(30) Priority: 30.09.1991 JP 251420/91
(71) Applicant: Chugai Ro Co., Ltd., Osaka-shi Osaka-fu (JP)
(72) Inventor: Murakami, Koji, Settsu-shi, Osaka-fu (JP)
(74) Representative: Glawe, Delfs, Moll & Partner

(57) **Abstract**

A rotatable hollow roll is contained in the vacuum vessel and a metal strip is bent along the rotatable hollow roll. The rotatable hollow roll consists of non-magnetic and conductive material and constitutes cathode. A magnet means is arranged in the hollow roll in the range that the metal strip is bent. An anode is supported on the internal surface of the vacuum vessel so that both side edges of the anode cover the hollow roll in the range that the magnet means is arranged. An discharge-proof plate is provided in the vicinity of both side edges of the anode, whereby a electric discharge space is formed between the anode and the hollow roll, and a electric discharge gas is fed to the electric discharge space. The magnetron discharge is concentrated on the range of bent portion of the metal strip on the hollow roll.

## Description

### BACKGROUND OF THE INVENTION

### 1. Field of the Invention

The present invention relates to a metal strip surface cleaning apparatus.

### 2. Description of the Prior Art

In case of continuously coating the metal strip by means of the dry coating equipment, it is desirable to clean the surface of the metal strip previously.

So, the cleaning process by the ion-bombard treatment has been carried out as a pretreatment of the dry process of the metal strip. The above ion-bombard treatment is the type of so-called "anode magnetron" in which the magnet is arranged near the anode.

In this ion-bombard treatment, however, the electron immediately reaches the anode, for the direction of the movement of the electron is correspond to that of the application of the electric potential. The above fact makes the time for the electron being trapped in the magnetic field short and makes the electron density low. Therefore the disadvantage of previous apparatus lies in that the enough density of the discharge current is not obtained and it takes long time to clean the metal strip surface and the stability of the electric discharge is not sufficient.

### SUMMARY OF THE INVENTION

The present invention has been developed to substantially eliminate the above-described disadvantages.

The object of the present invention is therefore to provide a metal strip surface cleaning apparatus which is capable of cleaning the metal strip surface with high efficiency and high speed.

In order to achieve the aforementioned objects, the metal strip surface cleaning apparatus according to the present invention, comprising
a vacuum vessel;
a rotatable hollow roll which is contained in the vacuum vessel and along which a metal strip is bent, the rotatable hollow roll consists of non-magnetic and conductive material and constitutes cathode;
a magnet means which is arranged in the hollow roll in the range that the metal strip is bent;
an anode which is supported on the internal surface of the vacuum vessel so that both side edges of the anode cover the hollow roll in the range that the magnet means is arranged; and
an discharge-proof plate which is provided in the vicinity of both side edges of the anode, whereby a electric discharge space is formed between the anode and the hollow roll, and a electric discharge gas is fed to the electric discharge space.

In the preferred embodiment the vacuum vessel may be provided with two sealing nozzles and a metal strip may be inserted into the vacuum vessel via the sealing nozzle and may be bent along the hollow roll and may be extended to the outside of the vacuum vessel via the sealing nozzle, so that the metal strip is capable of traveling from the sealing nozzle of inlet side to the sealing nozzle of outlet side as being guided by the hollow roll.

In the other preferred embodiment the side edge portion of the anode existing in the outlet side of the metal strip may be bent along the metal strip and may constitute an adherence-proof portion, a adherence-proof gas may be fed to the space between the adherence-proof portion and the metal strip.

According to the present invention, the magnetron discharge is concentrated on the range of bent portion of the metal strip on the hollow roll by means of the magnet arranged in the hollow roll and the discharge-proof plate provided in vicinity of both side edges of the anode, so the strip metal surface is cleaned with high spattering efficiency and high speed.

Moreover , the rotatable hollow roll is used as a cathode and the metal strip is bent on the hollow roll, so the path (space) for the metal strip to return is available and the installation space is saved.

### BRIEF DESCRIPTION OF THE DRAWINGS

This and other objects and features of the present invention will become clear from the following description taken in conjunction with the preferred embodiments thereof with reference to the accompanying drawings, in which:
Fig.1 is a cross-sectional view of the embodiment of the metal strip surface cleaning apparatus according to the present invention; and
Fig.2 is a graph showing the relation between gas pressure x anode-cathode distance and discharge starting voltage.

### DETAILED DESCRIPTION OF THE PREFERRED EMBODIMENTS

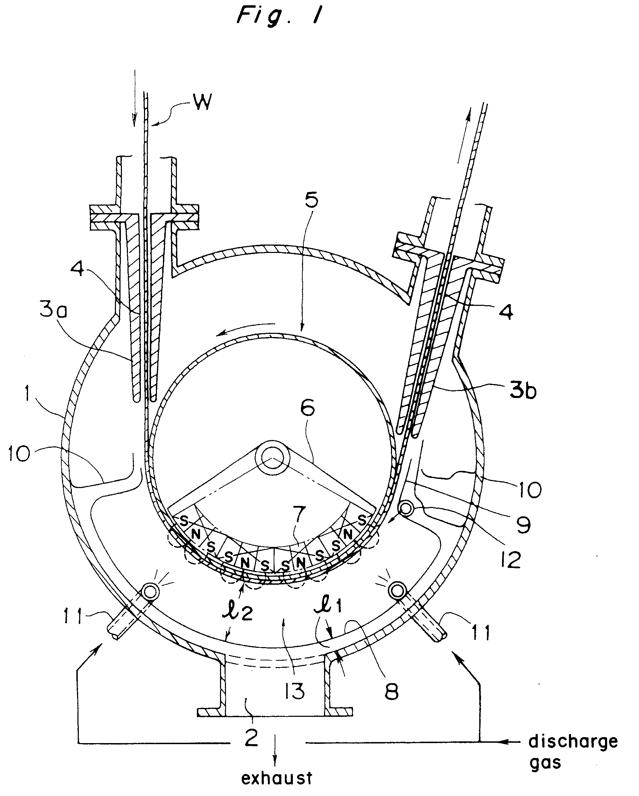

Referring now to Fig.1, there is shown a vacuum vessel 1 having circular cross section. In the vacuum vessel 1 a hollow roll 5 which constitutes a rotatable cathode is contained. The hollow roll 5 consists of non-magnetic and conductive material, for example, carbon, stainless steal, copper, copper alloy or metal material coated with conductive ceramic. The vacuum vessel 1 is provided with two sealing nozzles 3a, 3b. A metal strip W is inserted into the vacuum vessel 1 via the sealing nozzle 3a and is bent along the hollow roll 5 in a little over 1/3 range of the periphery of the hollow roll 5 and is extended to the outside of the vacuum vessel 1 via the sealing nozzle 3b, so that the metal strip W is capable of traveling from the sealing nozzle 3a of inlet side to the sealing nozzle 3b of outlet side as being guided by the hollow roll 5.

A magnet holder 6 is attached on both internal end walls of the vacuum vessel 1. A permanent magnets 7 having longer length than the width of the metal strip W is arranged in the hollow roll 5 in the range that the metal strip W is bent and is held by the magnet holders 6, so that there exists a little gap between the outer surface of the permanent magnets 7 and the internal surface of the hollow roll 5. Alternatively, the permanent magnets 7 may be replaced by electromagnets.

An anode 8 is supported on the internal surface of the hollow roll 5 with a small gap in the range opposed to the bent portion of the metal strip W. Both side edge portions of the anode 8 are bent and extended to the vicinity of the external surface of the hollow roll 5. Moreover the side edge portion of the anode 8 existing in the outlet side of the metal strip W is bent along the metal strip W and constitutes an adherence-proof portion 9. The space between the anode 8 and the hollow roll 5 (cathode) forms the electric discharge space 13. Alternatively, the anode 8 may be perforated.

In the vicinity of both side edges of the anode 8 a discharge-proof plate 10 one end of which secured to the internal surface of the vacuum vessel 1 is provided respectively.

The vacuum vessel 1 is provided with an exhaust port 2 to evacuate the vacuum vessel 1 with a vacuum pump not shown and hold a vacuum of 10⁻⁴ - 10⁻¹ Torr. The vacuum vessel 1 is also provided with discharge gas inlet nozzles 11 to feed the discharge gas, for example, Argon gas into the electric discharge space 13.

Aforementioned sealing nozzles 3a, 3b have an internal passage 4 of which cross sectional configuration is slightly larger than that of the metal strip W to prevent as much as possible the atmospheric air from infiltrating into the vacuum vessel 1. An adherence-proof gas nozzle 12 is provided in the vicinity of the adherence-proof portion 9.

The metal strip surface cleaning apparatus described above is operated as follows.

The vacuum vessel 1 is evacuated from the exhaust port 2 and is held a predetermined degree of vacuum, while the electric discharge gas is fed into the electric discharge space 13. A voltage is applied to the anode 8 and the hollow roll (cathode) 5 and then the metal strip W travels. The metal strip W constitutes the cathode because of being contacted with the hollow roll 5. The electric discharge, therefore, occurs in the electric discharge space 13 between the metal strip W and the anode 8. In this electric discharge process the electron is trapped by the magnetic field formed by the permanent magnets 7 and makes cycloid motion on the metal strip W so that the ionization of the discharge gas is accelerated. As a result, the electric discharge is concentrated on the range opposed to the permanent magnets 7. Then the surface of the metal strip W traveling along the said range receives ion-bombard so that the surface is slightly etched and cleaned.

The discharge-proof plate 10 prevents discharging in the range except for the electric discharge space 13.

The particles, i.e., atom or molecule etc. spattered from the metal strip W are prevented from scattering and adhering to the metal strip W again by means of the gas flow fed from the adherence-proof gas inlet nozzle 12 to the space between the adherence-proof portion 9 and the metal strip W.

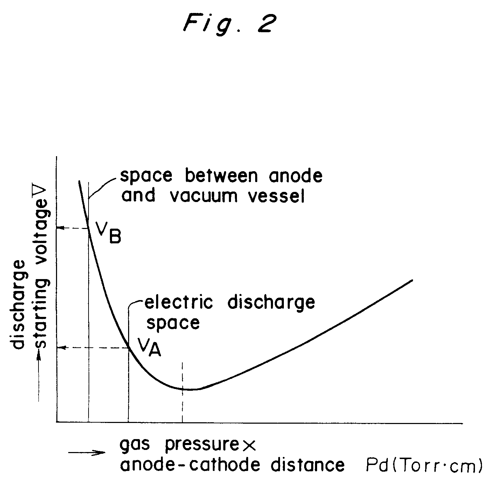

In this embodiment the distance l₁ between the anode 8 and the vacuum vessel 1 is comparatively smaller than the distance l₂ between the anode 8 and the hollow roll (cathode) 5 (i.e., l₁ is less than 1/3 of l₂), for the electric discharge in the electric discharge space 13 having large anode-cathode distance starts at lower voltage than that in the space between the anode 8 and the vacuum vessel 1 having small distance according to Fig.2 showing the relation between anode-cathode distance and discharge starting voltage based on Paschen's law.

Although the present invention has been fully described by way of the examples with reference to the accompanying drawing, it is to be noted here that various changes and modifications will be apparent to those skilled in the art. Therefore, unless such changes and modifications otherwise depart from the spirit and scope of the present invention, they should be construed as being included therein.

## Claims

1. A metal strip surface cleaning apparatus, comprising
a vacuum vessel;
a rotatable hollow roll which is contained in said vacuum vessel and along which a metal strip is bent, said rotatable hollow roll consists of non-magnetic and conductive material and constitutes cathode;
a magnet means which is arranged in said hollow roll in the range that said metal strip is bent;
an anode which is supported on the internal surface of said vacuum vessel so that both side edges of said anode cover said hollow roll in the range that said magnet means is arranged; and
an discharge-proof plate which is provided in the vicinity of both side edges of said anode, whereby a electric discharge space is formed between said anode and said hollow roll, and electric discharge gas is fed to said electric discharge space.

2. The metal strip surface cleaning apparatus according to claim 1, wherein said vacuum vessel is provided with two sealing nozzles and wherein a metal strip is inserted into said vacuum vessel via said sealing nozzle and is bent along said hollow roll and is extended to the outside of said vacuum vessel via said sealing nozzle, so that said metal strip is capable of traveling from said sealing nozzle of inlet side to said sealing nozzle of outlet side as being guided by said hollow roll.

3. The metal strip surface cleaning apparatus according to claim 1 or 2, wherein the side edge portion of said anode existing in the outlet side of said metal strip is bent along said metal strip and constitutes an adherence-proof portion, a adherence-proof gas is fed to the space between said adherence-proof portion and said metal strip.
